# EUROPEAN PATENT APPLICATION

(11) **EP 2 139 029 A1**
(43) Date of publication of application: **30.12.2009**
(21) Application number: 08739996.0
(22) Date of filing: 07.04.2008
(51) Int. Cl.: H01L 21/304, B24B 37/00, C09K 3/14

(54) **POLISHING AGENT COMPOSITION AND METHOD FOR MANUFACTURING SEMICONDUCTOR INTEGRATED CIRCUIT DEVICE**

(30) Priority: 17.04.2007 JP 2007108556
(71) Applicant: Asahi Glass Company, Limited, Chiyoda-ku Tokyo 100-8405 (JP)
(72) Inventor: TAKEMIYA, Satoshi, Tokyo 100-8405 (JP); ITO, Keiichi, Chigasaki-shi Kanagawa 253-8585 (JP)
(74) Representative: Müller-Boré & Partner Patentanwälte
(86) International application number: PCT/JP2008/056893
(87) International publication number: WO 2008/132983

(57) **Abstract**

Provided is a polishing agent composition for chemical mechanical polishing, which is used for polishing a surface of a semiconductor integrated circuit device to be polished. The polishing agent composition contains silica particles, one or more oxidizing agents selected from the group consisting of hydrogen peroxide, ammonium persulfate and potassium persulfate, a compound represented by formula (1), pullulan, one or more acids selected from the group consisting of nitric acid, sulfuric acid and carboxylic acids, and water, and has a pH within the range of 1-5. According to the present invention, a flat surface of an insulating layer having a buried metal interconnect can be attained in polishing of a surface to be polished during production of a semiconductor integrated circuit device. Further, a semiconductor integrated circuit device having a highly planarized multilayer structure can be obtained.

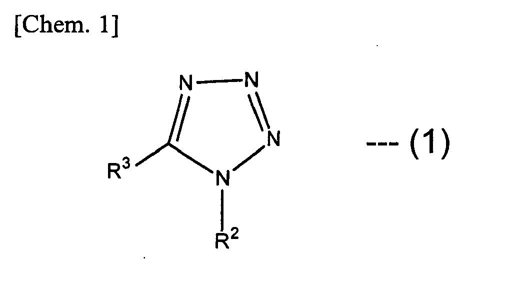

## Description

### TECHNICAL FIELD

The present invention relates to a polishing agent composition for chemical mechanical polishing, which is for use in a production process of a semiconductor integrated circuit device, and a method for manufacturing a semiconductor integrated circuit device. More specifically, the invention relates to a polishing agent composition for chemical mechanical polishing, which is suitable for forming a buried metal interconnect in which, for example, a copper metal is used as an interconnect material and a tantalum-based metal is used as a barrier layer material, and a method for manufacturing a semiconductor integrated circuit device using the same.

### BACKGROUND ART

With the recent progress toward higher integration and higher functionality of a semiconductor integrated circuit device, development of a micro fabrication technique for realizing refinement and high density has been advanced in a production process of the semiconductor integrated circuit device. In particular, a planar zing technique of an interlayer insulating film or a buried metal interconnect is important in a multilayer interconnect forming process.

As an interconnect material, attention has been focused on copper which is low in specific resistance and excellent in electro migration resistance. For copper interconnect formation, there is used a damascene process comprising forming trenches such as an interconnect pattern on an insulating layer, forming a barrier layer for preventing diffusion of copper, thereafter, forming a copper layer so as to be buried in the trenches by a sputtering method or a plating method, removing the excess copper layer and the barrier layer by a chemical mechanical polishing method (CMP, hereinafter referred to as CMP) until a surface of the insulating layer other than the trenches is exposed, and planar zing the surface, thereby forming buried metal interconnects. As the barrier layer, there is used a tantalum-based metal comprising tantalum, a tantalum alloy or a tantalum compound such as tantalum nitride.

In such buried copper interconnect formation, at portions other than buried interconnect portions, it is necessary to remove the barrier layer by CMP, which is exposed by removing the excess copper layer. However, the barrier layer is very hard compared to copper, so that a sufficient polishing rate is not obtained in many cases. There has been therefore proposed a two-step polishing method comprising a first polishing process for removing the excess metal interconnect layer and a second polishing process for removing the excess barrier layer.

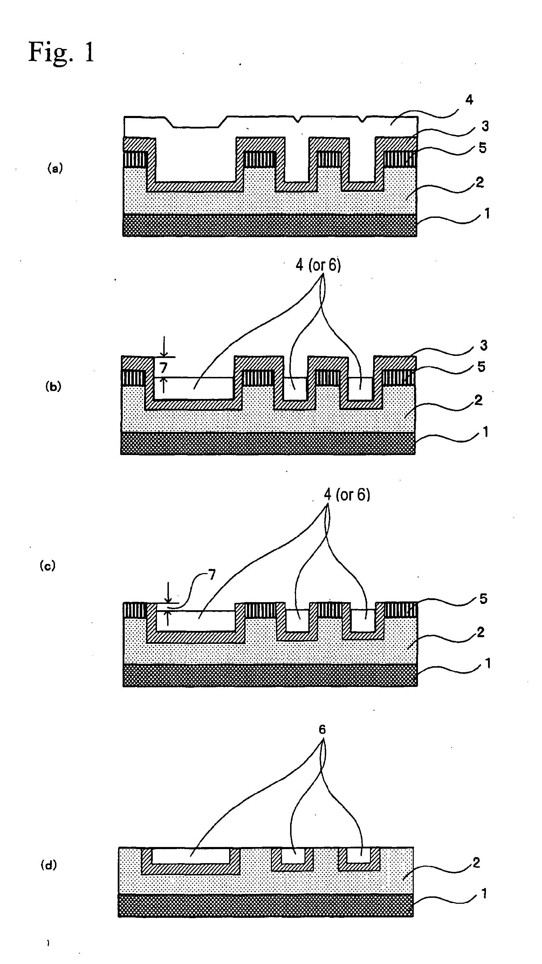

A method for forming the buried metal interconnects by CMP will be illustrated using Fig. 1. In Fig. 1, the case using a cap layer 5 comprising an insulating material such as silicon dioxide is exemplified, but no cap layer is sometimes used. The same also applies to such a case.

Fig. 1(a) is a cross-sectional view showing a state before polishing in which trenches for forming buried interconnects 6 are first formed in an insulating layer 2 and a cap layer 5 formed on a substrate 1, and then, a barrier layer 3 and a metal interconnect layer 4 are formed in this order. Fig. 1 (b) is a cross-sectional view after the first polishing process for removing the excess portions of the metal interconnect layer 4 is performed. After the first polishing process is completed, a decrease in the metal interconnect called dishing 7 indicated by the arrows in Fig. 1(b) or a decrease in the insulating layer called erosion 8 indicated by the arrows 8 in Fig. 1(b) occurs.

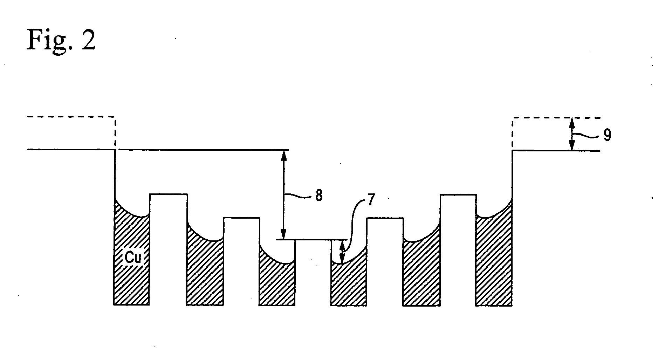

The dishing 7 means a dent at a center of an interconnect portion, which is generated by excessively polishing the metal interconnect layer, or the amount dented, as shown by the arrows 7 in Fig. 1(b) or Fig. 2. The erosion means a dent generated by rapid progress of polishing at a portion narrow in interconnect width or a portion high in interconnect density, of the interconnect portions, compared to an insulating layer portion (global portion) having no interconnect pattern, a portion wide in interconnect width or a portion low in interconnect density, which causes the insulating layer 2 to be excessively polished to the global portion, or the amount dented, as shown by the arrows 8 in Fig. 2. Incidentally, in Fig. 2, the barrier layer 3 is omitted.

By the second polishing process subsequently performed, the unnecessary barrier layer and cap layer 5 are removed by polishing, and the dishing and erosion generated in the first polishing process are removed to realize a flat surface in which the metal interconnect layer and the insulating layer are aligned to the same plane, as shown by a cross-sectional view of Fig. 1(d). Incidentally, the cap layer 5 is all removed in Fig. 1, but it is not necessarily all removed.

Fig. 1(c) is a cross-sectional view in the course of the second polishing process. The barrier layer exposed by removing the excess copper layer is removed, but the dishing 7 remains. When the dishing at the time when the first polishing process is completed is small, the flat surface in which the metal interconnect layer and the insulating layer are aligned to the same plane is obtained by scraping off the barrier layer and the cap layer. However, the dishing after the first polishing process is larger than the film thickness of the barrier layer, and polishing of the buried metal interconnects 6 also proceeds during the second polishing process. Accordingly, in order to obtain the flat surface, it is preferred that the insulating layer is further polished after the barrier layer and the cap layer are polished. Further, the erosion is also sometimes generated in the second polishing process. In that case, it is preferred that the insulating layer is further polished.

A polishing agent for use in the above-mentioned second polishing process has an action of decreasing dishing, erosion and scratches which cause an increase in interconnect resistance or electromigration to reduce reliability of the device. Further, it is preferred that the above-mentioned polishing agent has a similar polishing rate, that is, "nonselective" to the metal interconnect layer, the barrier layer and the insulating layer such as silicon dioxide or a low dielectric film.

Tantalum or the tantalum compound used as the barrier layer is chemically stable, difficult to be etched and hard in hardness, compared to copper. It has therefore a low polishing rate relative to the copper layer, and it is difficult to obtain an equivalent polishing rate. There are problems that when the hardness of abrasive grains is increased in order to increase the polishing rate, scratches occur on the copper interconnects to cause electric failure or the like, and that when the concentration of abrasive grains is increased, dispersion stability of the polishing agent is decreased to be liable to result in occurrence of sedimentation or gelation with time.

Further, it is described, for example, in patent document 1 that in order to inhibit the occurrence of dishing or erosion and to obtain a desired polishing rate ratio of barrier layer: metal interconnect layer: insulating layer in the second polishing process, a protection film-forming agent comprising a triazole-based compound including benzotriazole (hereinafter referred to as BTA) is added to a polishing agent composition. Furthermore, a polishing agent composition in which pullulan is allowed to be contained is described in patent document 2. However, addition of the protection film-forming agent of the triazole-based compound largely decreases the copper polishing rate, resulting in requirement of a long period of time for polishing, which causes a fear of increasing dishing or erosion rather than decreasing. In addition, this agent is strongly adsorbed by copper and a copper alloy, so that it is difficult to remove it. Accordingly, there is a fear of exerting an adverse effect on the subsequent process. Further, it is described that the polishing rate of this polishing agent composition for the barrier layer and the insulating layer is about twice the polishing rate for the copper film.

Patent document 3 describes a polishing agent composition comprising a compound of formula (1), hydrogen peroxide or ammonium persulfate as an oxidizing agent, and glycine, malic acid, tartaric acid or alanine as an acid, and having a pH of 3.2 to 10. However, this polishing agent composition is a polishing agent for a first polishing process in which a metal film comprising a copper alloy is polished:

Further, patent document 4 describes a polishing agent composition comprising 5-amino-1H-tetrazole (HAT) as a polishing rate adjusting agent and silica particles as abrasive grains, and adjusted to pH 3 to 6.5 by using nitric acid. However, the polishing agent composition of patent document 4 has a copper film/barrier layer polishing rate ratio of about 1/(40 to 50) and a copper film/insulating layer polishing rate ratio of 0.6 to 1.25.

Patent Document 1: PCT International Publication No. 2003/036705
Patent Document 2: JP-A-2005-294798
Patent Document 3: JP-A-2006-049790
Patent Document 4: JP-A-2001-77062

### DISCLOSURE OF THE INVENTION

### PROBLEMS TO BE SOLVED BY THE INVENTION

An object of the invention is to realize a flat surface to be polished of an insulating layer and buried metal interconnects embedded therein by CMP in a process for forming buried metal interconnects in the production of a semiconductor integrated circuit device. Other objects and advantages of the invention will become apparent from the following description.

### MEANS FOR SOLVING THE PROBLEMS

Embodiment 1 of the invention provides a polishing agent composition for use in the production of a semiconductor integrated circuit device, which comprises silica particles, one or more oxidizing agents selected from the group consisting of hydrogen peroxide, ammonium persulfate and potassium persulfate, a compound represented by formula (1) (wherein R² and R³ are each independently a hydrogen atom, an alkyl group having 1 to 4 carbon atoms, an alkoxy group having 1 to 4 carbon atoms, a carboxylic acid group or an amino group), pullulan, one or more acids selected from the group consisting of nitric acid, sulfuric acid and carboxylic acids, and water, and which has a pH within the range of 1 to 5.

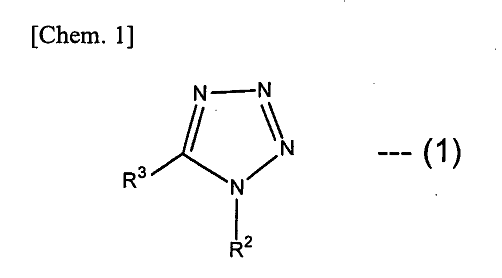

The use of the polishing agent composition of this embodiment makes it possible to highly flatly polish a surface to be polished in CMP of a production process of buried metal interconnects in a production process of the semiconductor integrated circuit device. Thereby, a semiconductor integrated circuit device having a highly planarized multilayer structure can be obtained. Further, washing of the surface to be polished after CMP is easy, so that an adverse effect on the subsequent process, which is caused by that components of the polishing agent composition are adsorbed and remain, can be inhibited.

Embodiment 2 of the invention provides the polishing agent composition of embodiment 1, wherein the composition contains 0.1 to 20% by mass of the silica particles, 0.01 to 50% by mass of the oxidizing agent, 0.001 to 5% by mass of the compound represented by formula (1) and 0.005 to 20% by mass of pullulan, based on the total amount of the above-mentioned polishing agent composition.
In this case, the surface to be polished can be further highly flatly polished in CMP of the production process of the buried metal interconnects in the production process of the semiconductor integrated circuit device, in addition to the effects of embodiment 1. Thereby, a semiconductor integrated circuit device having a further highly planarized multilayer structure can be obtained.

Embodiment 3 of the invention provides the polishing agent composition of embodiment 1 or 2, wherein the oxidizing agent is hydrogen peroxide, and the compound represented by formula (1) is 5-amino-1H-tetrazole.
In this case, the surface to be polished can be still further highly flatly polished in CMP of the production process of the buried metal interconnects in the production process of the semiconductor integrated circuit device, in addition to the effects of embodiment 1 or 2. Thereby, a semiconductor integrated circuit device having a still further highly planarized multilayer structure can be obtained.

Embodiment 4 of the invention provides the polishing agent composition of embodiment 1, 2 or 3, wherein the above-mentioned silica particles have an average particle size of 5 to 300 nm.
In this case, the occurrence of scratches at the time of polishing on the surface to be polished having a copper layer, a barrier layer and an insulating layer is inhibited, and good dispersibility of the polishing agent composition is realized, in addition to the effects of embodiment 1, 2 or 3.

Embodiment 5 of the invention provides the polishing agent composition of any one of embodiments 1 to 4, wherein the composition further comprises one or more members selected from the group consisting of polyacrylic acid and polyvinyl alcohol.
In this case, the surface to be polished having the copper layer, the barrier layer and the insulating layer can be further highly flatly polished, in addition to the effects of any one of embodiments 1 to 4. Further, similar polishing characteristics are realized in the insulating layer, even when it has a cap layer.

Embodiment 6 of the invention provides the polishing agent composition of embodiment 5, wherein the composition comprises one or more members selected from the group consisting of polyacrylic acid and polyvinyl alcohol in an amount of 0.005 to 20% by mass based on the total amount of the polishing agent composition.
In this case, higher flat polishing characteristics are realized, in addition to the effects of embodiment 5.

Embodiment 7 of the invention provides the polishing agent composition of any one of embodiments 1 to 6, wherein a ratio PR_{cu}/PR_{br} of a copper layer polishing rate PR_{cu} to a barrier layer polishing rate PR_{br}, a ratio PR_{cu}/PR_{sioc} of a copper layer polishing rate PR_{cu} to a SiOC layer polishing rate PR_{sioc}, a ratio PR_{cu}/PRₛᵢₒ₂ of a copper layer polishing rate PR_{cu} to a SiO₂ layer polishing rate PRₛᵢₒ₂, and a ratio PR_{sioc}/PRₛᵢₒ₂ of a SiOC layer polishing rate PR_{sioc} to a SiO₂ layer polishing rate PRₛᵢₒ₂ are each from 0.67 to 1.5.
In this case, the surface to be polished having the copper layer, the barrier layer and the insulating layer can be highly flatly polished, in addition to the effects of any one of embodiments 1 to 6. Further, the insulating layer and the cap layer can be polished at a similar polishing rate, so that they can be similarly highly flatly polished.

Embodiment 8 of the invention provides a method for producing a semiconductor integrated circuit device, wherein the semiconductor integrated circuit device comprises an insulating layer having trench portions and buried metal interconnects formed in the above-mentioned trench portions, the method comprising a step of polishing a surface to be polished which comprises a barrier layer and a metal interconnect layer are formed in this order in the above-mentioned trench portions, using the polishing agent composition described in any one of embodiments 1 to 7, to form the above-mentioned buried metal interconnects.

According to the semiconductor integrate circuit device production method of this embodiment, the surface to be polished can be highly flatly polished in CMP of the production process of the buried metal interconnects, so that the semiconductor integrated circuit device having a multilayer structure in which the highly planarized buried interconnects are formed in multilayers can be obtained. Further, washing of the surface to be polished after CMP is easy, so that an adverse effect on the subsequent process, which is caused by that components of the polishing agent composition are adsorbed and remain, can be inhibited.

Embodiment 9 of the invention provides the method for producing a semiconductor integrated circuit device in embodiment 8, wherein the above-mentioned metal interconnect layer comprises copper as a main component, and the above-mentioned barrier layer comprises one or more members selected from the group consisting of tantalum, tantalum alloys and tantalum compounds.
In this case, there can be produced a semiconductor integrated circuit device in which diffusion of copper in the insulating layer is sufficiently prevented, and which has good flatness and can be laminated in multilayers, in addition to the effects of embodiment 8.

Embodiment 10 of the invention provides the method for producing a semiconductor integrated circuit device in embodiment 8 or 9, wherein the above-mentioned insulating layer comprises a low dielectric insulating layer comprising a low dielectric material and a cap layer formed thereon, and the above-mentioned barrier layer and the above-mentioned metal interconnect layer are formed on the above-mentioned trench portions and the above-mentioned cap layer.
In this case, a semiconductor integrated circuit device which is more improved in flatness and is capable of additional multi-layering can be produced, in addition to the effects of embodiment 8 or 9.

### ADVANTAGES OF THE INVENTION

The use of the polishing agent composition of the invention makes it possible to highly flatly polish the surface to be polished in CMP of the production process of the buried metal interconnects in the production process of the semiconductor integrated circuit device. Thereby, a semiconductor integrated circuit device having a highly planarized multilayer structure can be obtained. Further, washing of the surface to be polished after CMP is easy, so that an adverse effect on the subsequent process, which is caused by that components of the polishing agent composition are adsorbed and remain, can be inhibited. Further, a semiconductor integrated circuit device having a highly planarized multilayer structure can be obtained.

### BRIEF DESCRIPTION OF THE DRAWINGS

[Fig. 1] Figs. 1(a) to 1(d) are schematic cross-sectional views of a semiconductor integrated circuit device in a process showing method for forming buried interconnects by CMP.
[Fig. 2] Fig. 2 is a schematic cross-sectional view of a semiconductor integrated circuit device for illustrating definitions of dishing and erosion.

### DESCRIPTION OF REFERENCE NUMERALS AND SIGNS

1: Si Substrate
2: Insulating Layer
3: Barrier Layer
4: Metal Interconnect Layer
5: Cap Layer
6: Buried Interconnect
7: Dishing Portion
8: Erosion Portion
9: Polished Part of Global Portion

### BEST MODE FOR CARRYING OUT THE INVENTION

The embodiments of the invention will be described below by using drawings, tables, formulas, examples and the like. Incidentally, these drawings, tables, formulas, examples and the like as well as description thereof are only for exemplifying the invention and should not be construed as limiting the scope of the invention. Other embodiments may belong to the scope of the invention, as long as they fall within the spirit of the invention.

The polishing agent composition of the invention is a polishing agent composition for CMP for polishing a surface to be polished in the production of a semiconductor integrated circuit device, and comprises silica particles, one or more oxidizing agents selected from the group consisting of hydrogen peroxide, ammonium persulfate and potassium persulfate, a compound represented by formula (1) (wherein R² and R³ are each independently a hydrogen atom, an alkyl group having 1 to 4 carbon atoms, an alkoxy group having 1 to 4 carbon atoms, a carboxylic acid group or an amino group), pullulan, one or more acids selected from the group consisting of nitric acid, sulfuric acid and carboxylic acids, and water, and has a pH within the range of 1 to 5.

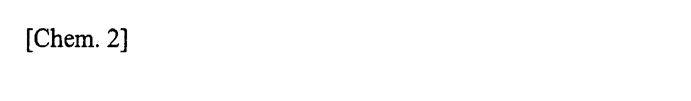

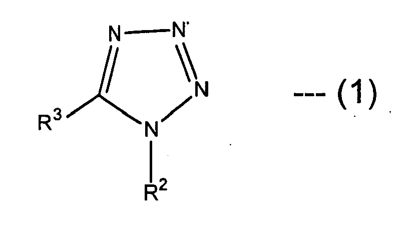

### <Silica Particles>

The silica particles may be any as long as they are particles mainly composed silica, and ones produced by various known methods can be used. For example, colloidal silica prepared from an alkoxide compound or sodium silicate, or fumed silica which is vapor-phase synthesized from silicon tetrachloride can be used. Above all, colloidal silica is preferred in that the particle size is easily controlled to be able to obtain a high-purity product.

From the aspects of polishing characteristics and dispersion stability, the average particle size of the silica particles is preferably within the range of 5 to 300 nm. Considering the polishing rate, wafer in-plane uniformity of the polishing rate, dispersion stability and the like, it is preferred that the concentration of the silica particles is appropriately set within the range of 0.1 to 20% by mass based on the total amount of the polishing agent composition, and it is more preferred that the concentration is within the range of 1 to 15% by mass based on the total amount of the polishing agent composition. The concentration of each component in the polishing agent composition is percent by mass based on the total amount of the polishing agent composition, unless otherwise specified.

Abrasive grains other than the silica particles may be contained in the polishing agent composition of the invention. However, the main component (50% or more by mass ratio) of the abrasive grains is the above-mentioned silica particles, and preferably, 50 to 100% of the abrasive grains are the above-mentioned silica particles. The total amount of the abrasive grains mainly composed of the above-mentioned silica particles is preferably within the range of 0.1 to 20% by mass based on the total amount of the polishing agent composition, and more preferably, within the range of 1 to 15% by mass based on the total amount of the polishing agent composition. As the abrasive grains other than the silica particles, specifically, there can be used colloidal alumina particles, cerium oxide particles prepared by a liquid-phase method or a vapor-phase method, zirconium oxide particles, titanium oxide particles, tin oxide particles, zinc oxide particles or manganese oxide particles. The average particle size of these particles is preferably within the range of 5 to 300 nm.

### <Oxidizing Agent>

It is conceivable that the oxidizing agent forms an oxide film on the surface of the barrier layer, and that this oxide film is removed by mechanical force from the surface to be polished, thereby accelerating the polishing of the barrier layer.

As the oxidizing agent, one or more members selected from the group consisting of hydrogen peroxide, iodates, periodates, hypochlorites, perchlorates, persulfates, percarbonates, perborates and superphosphates can be used. As the above-mentioned salt, a salt such as an ammonium salt or a potassium salt is preferably used. That is, as the oxidizing agent, preferred is hydrogen peroxide, ammonium persulfate, potassium persulfate or the like. Hydrogen peroxide containing no alkali metal component and producing no hazardous by-product is preferred.
Incidentally, the oxidizing agent has an extremely high decomposition rate, so that polishing is usually performed by preparing a polishing agent composition containing no oxidizing agent, and adding the oxidizing agent just before the polishing is performed.

From the standpoint of obtaining a sufficient effect of polishing acceleration, it is preferred that the concentration of the oxidizing agent in the polishing agent composition is appropriately set within the range of 0.01 to 50% by mass based on the total amount of the polishing agent composition, taking into consideration the polishing rate and the like. It is more preferably within the range of 0.2 to 20% by mass based on the total amount of the polishing agent composition.

### <Compound Represented by Formula (1)>

It is conceivable that the compound represented by formula (1) is physically or chemically adsorbed by the surface of the metal interconnect layer in polishing to form a film, thereby preventing elution of the metal interconnect layer to achieve a function of preventing dishing of the metal interconnect layer.

In formula (1), R² and R³ are each independently a hydrogen atom, an alkyl group having 1 to 4 carbon atoms, an alkoxy group having 1 to 4 carbon atoms, a carboxylic acid group or an amino group. R² and R³ are preferably a methyl group in the case of the alkyl group, and preferably a methoxy group in the case of an alkoxy group. Specifically, the compounds represented by formula (1) include 1H-tetrazole (1HT), 5-amino-1H-tetrazole (HAT), 5-methyl-1H-tetrazole (M5T) and the like. Above all, 5-amino-1H-tetrazole (HAT) and 1H-tetrazole (1HT) are preferably used. These may be used either alone or as a mixture of two or more thereof. The concentration of the compound represented by formula (1) is preferably within the range of 0.001 to 5% by mass from the standpoint of polishing characteristics. When it is 0.01 % by mass or more, more excellent polishing flatness is realized. In order to obtain more excellent dispersion stability by preventing coagulation of the polishing agent composition, it is preferably 2.0% by mass or less. From the viewpoint of copper polishing rate, the concentration of BTA is preferably 1% by mass or less, and particularly preferably 0.05% by mass or less.

### <Pullulan>

The use of the polishing agent to which pullulan is added accelerates polishing of an insulating layer portion (global portion) having no interconnect pattern, a portion wide in interconnect width or a portion low in interconnect density, of the interconnect portions, although the reason for this is unclear. As a result, the polishing of a portion narrow in interconnect width or a portion high in interconnect density is inhibited, so that erosion is reduced to enable flat polishing. It is presumed that this is the reason for the flat polishing enabled.

Pullulan is a polysaccharide in which maltotriose units consisting of three α-1,4-linked glucose molecules are further linked by α-1,6-bonds. It is preferred that pullulan has a weight average molecular weight ranging from 10,000 to 1,000,000, because of its high effect. With respect of the reason for this, it is considered that the presence of hydroxyl groups becomes an important factor. When the weight average molecular weight is less than 10,000, the effect of improving the polishing rate is small. Even when it exceeds 1,000,000, a marked increase in the effect is not expected. In particular, it is preferably within the range of 50,000 to 300,000. Incidentally, the weight average molecular weight can be measured by gel permeation chromatography (GPC).

From the standpoint of obtaining the sufficient effect of polishing acceleration, it is preferred that the concentration of pullulan in the polishing agent is appropriately set within the range of 0.005 to 20% by mass, taking into consideration the polishing rate, uniformity of a polishing agent slurry and the like. It is particularly preferably within the range of 0.05 to 2% by mass.

### <Water, Acid and pH>

Water is a solvent for dispersing the abrasive grains and dissolving the agents, and is preferably pure water or deionized water. Water has a function of controlling fluidity of this polishing agent, so that the content thereof can be appropriately set in accordance with targeted polishing characteristics such as the polishing rate and planarization characteristics.

It is preferred that the polishing agent contains an acid. As the acid, one or more members selected from the group consisting of nitric acid, sulfuric acid and carboxylic acids are preferred, and nitric acid which is an oxo acid having oxidizability and contains no halogen is preferred among others. The concentration of the acid is preferably within the range of 0.01 to 20% by mass. The polishing rate of the barrier layer or the insulating layer is changed by adjusting the amount of the acid added, thereby being able to adjust the polishing rate ratio of the barrier layer or the insulating layer to the metal interconnect layer. Further, it is also possible to improve dispersion stability of the polishing agent.

The above-mentioned acid may be partially replaced by an organic acid. As the organic acid, citric acid, tartaric acid, malic acid or oxalic acid can be used, and citric acid is preferably used. These organic acids are preferred because they have a pH buffering effect in addition.

Further, a basic compound may be added into this polishing agent together with the acid. As the basic compound, ammonium, potassium hydroxide or a quaternary ammonium hydroxide such as tetramethylammonium hydroxide or tetraethylammonium hydroxide (hereinafter referred to as TEAH) can be used, and ammonium is preferably used.

The pH of this polishing agent is from 1 to 5, taking into consideration various factors such as polishing characteristics, washability of the surface to be polished after polishing and dispersion stability of the polishing agent. Silica has an isoelectric point of 2.5, and it has hitherto been considered that it is difficult to prepare a polishing agent composition excellent in dispersion stability in this strongly acidic pH region. In contrast, as a result of intensive studies, the present inventors have found the polishing agent composition providing the desired polishing rate ratio of Ta, Cu and the insulating layer, realizing easy washing of the surface to be polished after polishing, extremely excellent in dispersion stability and good in stability at the time of storage, even in this strongly acidic region which has hitherto been considered to be difficult, by using abrasive grains mainly composed of silica, one or more oxidizing agents selected from the group consisting of hydrogen peroxide, ammonium persulfate and potassium persulfate, a compound represented by formula (1) (wherein R² and R³ are each independently a hydrogen atom, an alkyl group having 1 to 4 carbon atoms, an alkoxy group having 1 to 4 carbon atoms, a carboxylic acid group or an amino group), pullulan, one or more acids selected from the group consisting of nitric acid, sulfuric acid and carboxylic acids, and water, in combination, thus attaining the invention. This is presumed because electrostatic repulsion or a steric hindrance function occurs by an interaction of the particles and the polishing agent components, and this function prevents adhesion, coagulation, precipitation, gelation and the like of the particles. Taking into consideration dispersion stability of the polishing agent at the time when it is stored for a long period of time, the pH is more preferably 3.5 or less. Further, taking into consideration corrosion of the surface to be polished, it is preferably 1.5 or more.

### <Water-Soluble Polymer>

It is desirable that the polishing agent according to the invention further contains a water-soluble polymer, because an effect of preventing dishing (a phenomenon that the barrier layer and the insulating layer adjacent to the barrier layer are excessively polished and locally dented as compared with the metal interconnect layer) is enhanced.

As the water-soluble polymer, there is preferably used one or more members selected from the group consisting of polyacrylic acid and polyvinyl alcohol. Polyacrylic acid may be the ammonium salt, potassium salt or amine salt thereof, and it is more preferred to use the ammonium salt. When the water-soluble polymer is allowed to be contained in this polishing agent, the content thereof is preferably from 0.005 to 20% by mass, and particularly preferably from 0.05 to 2% by mass, based on the total amount of the polishing agent. When the polyacrylic acid salt is used, the content shall be understood to mean the amount converted to polyacrylic acid.

### <Organic Solvent>

In order to control the fluidity, dispersion stability and polishing rate of the polishing agent composition, it is preferred to add one or more organic solvents selected from the group consisting of a primary alcohol having 1 to 4 carbon atoms, a glycol having 2 to 4 carbon atoms and a propylene glycol monoalkyl ether represented by formula (2):

CH₃CH(OH)CH₂O-CₘH₂ₘ₊₁ (2)

(provided that m is an integer of 1 to 4), N-methyl-2-pyrrolidone, N,N-dimethylformamide, dimethyl sulfoxide, γ-butyrolactone and propylene carbonate. Specifically, as the primary alcohol, preferred is methyl alcohol, ethyl alcohol or isopropyl alcohol. As the glycol, preferred is ethylene glycol or propylene glycol. The above-mentioned ethers include propylene glycol monomethyl ether and propylene glycol monoethyl ether. The content of the above-mentioned organic solvent is preferably from 0.1 to 10% by mass based on the total amount of the polishing agent.

### <Other Components>

The polishing agent composition according to the invention may contain a pH buffering agent, a surfactant, a chelating agent, a reducing agent, a viscosity-imparting agent or viscosity-controlling agent, a coagulation-preventing agent or dispersant, an anticorrosive agent or the like as needed, as long as the effects of the invention are obtained. However, when these agents have the function of an oxidizing agent, an acid, a step-eliminating agent or a viscosity-adjusting agent, they are treated as the oxidizing agent, the acid, the step-eliminating agent or the viscosity-adjusting agent.

### <Material to Be Polished>

The polishing agent composition according to the invention is suitable for obtaining the flat surface of the insulating layer having the buried metal interconnect layer, in the production of the semiconductor integrated circuit device. In particular, it is suitable for polishing the surface to be polished, which is formed by laminating the barrier layer and the metal interconnect layer on the insulating layer on which trenches for metal interconnects are formed. That is, the polishing agent composition according to the invention has both functions of high speed polishing of the barrier layer and planarization of the insulating layer having the buried metal interconnect layer at once.

In particular, when the barrier layer is a layer comprising one or more members selected from the group consisting of tantalum, tantalum alloys and tantalum compounds, a high planarizing effect is obtained. However, it can also be applied to a film comprising another metal or the like. Even when a film comprising a metal other than tantalum or a metal compound, for example, a film comprising Ti, TiN, TiSiN, WN or the like, is used as the barrier layer, a sufficient effect is obtained.

As a material constituting the insulating layer which is one of subjects to be polished by the polishing agent composition according to the invention, any known one may be used. For example, a silicon dioxide film is exemplified. As the silicon dioxide film, there is generally used one having a bridging structure of Si and O, in which the ratio of the number of atoms of Si and O is 1:2, but one other than this may also be employed. As such a silicon dioxide film, there is commonly known one deposited by plasma-CVD using tetraethoxysilane (TEOS) or silane gas (SiH₄).

Further, the polishing agent composition according to the invention can also be suitably used to a film comprising a low-dielectric material having a specific dielectric coefficient of 3 or less, which has recently come to be used as an insulating layer for the purpose of inhibiting signal delay, for example, a film comprising fluorine-added silicon oxide (SiOF), an organic SOG film (a film containing an organic component obtained by spin-on-glass), a low-dielectric material film such as a porous silica film, or an organic silicon material (generally indicated as SiOC) film mainly constituted by Si-O bonds and containing Si-CH₃ bonds.

The organic silicon materials, which are a low-dielectric material, include Black Diamond (trade name, specific dielectric coefficient: 2.7, developed by Applied Materials, Inc.), Coral (trade name, specific dielectric coefficient: 2.7, developed by Novellous Systems, Inc.), Aurora 2.7 (specific dielectric coefficient: 2.7, developed by Japan ASM, Inc.) and the like, and above all, a Si-CH₃ bond-containing compound is preferably used.

The polishing agent composition according to the invention can also be suitably used when the cap layer is formed on the insulating layer. For example, in a multi-layer structure in which the cap layer, the barrier layer and the metal interconnect layer are successively laminated on the low-dielectric insulating layer, it is suitable for scraping the insulating layer to perform planarization, after the cap layer is completely removed.

The cap layer is a layer provided for the purpose of increasing adhesiveness between the insulating layer and the barrier layer when the low-dielectric material is used in the insulating layer, using the cap layer as a mask material at the time when trenches for embedding the metal interconnect layer in the low-dielectric insulating layer which is chemically, mechanically fragile, or preventing deterioration of the low-dielectric material.

As the cap layer, a film having silicon and oxygen as constituents is generally used. As such a film, a silicon dioxide film can be exemplified. As the silicon dioxide film, there is generally used one having a bridging structure of Si and O wherein the ratio of numbers of Si and O atoms is 1:2, but a film other than this may also be used. As such a silicon dioxide film, there is commonly known one deposited by plasma CVD using tetraethoxysilane (TEOS) or silane gas (SiH₄).

The polishing agent composition according to the invention can be particularly suitably used when such a silicon dioxide film formed by depositing tetraethoxysilane (TEOS) by CVD is used and Black Diamond (trade name, specific dielectric coefficient: 2.7, developed by Applied Materials, Inc.) which is the Si-CH₃ bond-containing compound is used as the organic silicon material of the low-dielectric material.

When the metal interconnect layer which is a subject to be polished by the polishing agent composition according to the invention is formed of at least one selected from the group consisting of copper, copper alloys and copper compounds, the high effect is obtained. However, the polishing agent composition of the invention is also applicable to a metal layer of a metal other than copper, for example, W, Ag, Pt, Au or the like.

The polishing agent composition of the invention can be applied to a polishing method of supplying the polishing agent composition to a polishing pad, bringing it into contact with the surface to be polished, and allowing the relative movement of the surface to be polished and the polishing pad to each other. Polishing may be performed while bringing a pad conditioner into contact with a surface of the polishing pad to condition the surface of the polishing pad, as needed.

The polishing agent composition according to the invention is not necessarily supplied to a polishing place in a state where all polishing materials constituting the composition are previously mixed, and all polishing materials constituting the polishing agent composition according to the invention may be mixed at the time when polishing is performed.

The polishing agent composition according to the invention can polish the surface to be polished, which is formed by laminating the barrier layer and the metal interconnect layer on the insulating layer, at a similar polishing rate to the copper layer, the barrier layer and the insulating layer, by containing the abrasive grains, the oxidizing agent, the compound represented by formula (1), pullulan, the acid and water, and having a pH within the range of 1 to 5.
That is, the ratio (PR_{cu}/PR_{br}) of a copper layer polishing rate PR_{cu} to a barrier layer polishing rate PR_{br}, a ratio (PR_{cu}/PR_{sioc}) of a copper layer polishing rate PR_{cu} to a SiOC layer polishing rate PR_{sioc}, a ratio (PR_{cu}/PRₛᵢₒ₂) of a copper layer polishing rate PRcᵤ to a SiO₂ layer polishing rate PRₛᵢₒ₂, and a ratio (PR_{sioc}/PRₛᵢₒ₂) of a SiOC layer polishing rate PR_{sioc} to a SiO₂ lay polishing rate PRₛᵢₒ₂ are each from 0.67 to 1.5. The polishing rate of each of the copper layer, the barrier layer, the SiO₂ layer and the SiOC layer was determined by conducting a polishing test to a blanket wafer of each layer.

The polishing agent composition according to the invention has the above-mentioned characteristics, so that it is suitably used for a method in which in the surface to be polished, which is obtained by forming concave portions such as trench patterns or via holes for interconnects on the insulating layer on a substrate, and in order to embed a metal, for example, copper, in the concave portions, forming a film thereof by a sputtering method, a plating method or the like, after the barrier layer is formed, the metal and barrier layer are removed by CMP until the surface of the insulating layer other than the concave portions are exposed to form the buried metal interconnects.

It is considered that such characteristics are obtained by fusion of chemical polishing caused by agent composition of the polishing agent composition and physical polishing brought about by the abrasive grains in the CMP technique, and this is an effect which can not be realized by the conventional polishing agent compositions. Further, on the surface to be polished after polishing has been performed using this polishing agent, adsorption and retention of the components of the polishing agent composition are extremely slight, so that the adverse effect on the subsequent process due to residues can be inhibited.

### EXAMPLES

The invention will be more specifically described below with reference to Examples 1 to 3 and 7 corresponding to Examples of the invention, Examples 4 to 6, 8 and 17 corresponding to Comparative Examples, and Examples 9 to 16 corresponding to Reference Examples.

### (1) Preparation of Polishing Agent Composition

Respective polishing agent compositions of Examples 1 to 16 were each prepared in the following manner. An acid, a compound represented by formula (1) and pullulan were added to water, followed by stirring for 10 minutes. Pure water was used as water. When an organic solvent was used, water and the organic solvent were previously mixed before addition of the respective components to prepare a mixed solvent. Further, when a basic compound and a water-soluble polymer were allowed to be contained, they were allowed to be contained before stirring and stirred together with the above-mentioned components.

Then, an aqueous dispersion of abrasive grains was slowly added, followed by stirring for 30 minutes to obtain each polishing agent composition. The concentration (% by mass) of each component used in each Example based on the total amount of the polishing agent composition is as shown in Tables 1 and 3, and water is the remainder of the total amount of the respective components.

### (2) Measurement of Average Particle Size of Polishing Agent Composition

The average particle size of the polishing agent compositions of Examples 9 to 16 was measured by using Microtrac UPA (manufactured by Nikkiso Co., Ltd.). The polishing agent compositions of respective formulations were prepared, and the initial average particle size was first measured. Then, the polishing agent compositions prepared were stored at room temperature for 10 days, and the average particle size after storage was measured. Dispersion stability of the polishing agent compositions was evaluated from a change in average particle size before and after the storage. Further, as dispersion stability under accelerated conditions, the average particle size after storage at 55°C was measured.

For the polishing agent compositions of the respective formulations of Examples 9 to 16 shown in Table 3, the initial average particle size, the average particle size after storage at room temperature for 10 days and the average particle size after storage at 55°C for 3 days were measured. The results thereof are summarized in Table 4. Although the polishing agent compositions of Examples 9 to 16 do not contain the respective components of the oxidizing agent, pullulan and the water-soluble polymer, these components have substantially no effect on dispersion stability. It is therefore possible to estimate to some degree to what extent dispersion stability is changed by changing the pH value. Examples 9 to 16 are Reference Examples in which the pH of the polishing agent compositions is changed between 1 and 7 while maintaining the contents of silica, HAT and the like.
The results described in Table 4 showing the particle size of Examples 9 to 16 reveals that for Examples 9 to 14, the average particle size after storage at 55°C for 3 days is small to be excellent in dispersion stability. On the other hand, for Examples 15 and 16, the average particle size is large to be deteriorated in dispersion stability. It is therefore presumed that for the polishing agent composition of the invention, the preferred range of the pH value is from 1 to 5.

### (3) Polishing Conditions

Polishing was performed using the following apparatus and conditions for the polishing agent compositions of Examples 1 to 8.

Polishing machine: full-automatic CMP apparatus MIRRA (manufactured by Applied Materials, Inc.)
Polishing pressure: 14 kPa
Rotation speed: platen (surface plate); 103 rotation/min (rpm), head (substrate holder); 97 rpm
Polishing agent composition supply rate: 200 ml/min
Polishing pad: IC1400-k groove (manufactured by Rodel, Inc.)

### (4) Material to Be Polished

Blanket wafers of the following (a) to (d) were used.

### (a) Wafer for Metal Interconnect Layer (Copper Layer) Polishing Rate Evaluation

An 8-inch wafer obtained by forming a 1500-nm thick copper layer on a substrate by plating was used.

### (b) Wafer for Barrier Layer (Tantalum Layer) Polishing Rate Evaluation

An 8-inch wafer obtained by forming a 200-nm thick tantalum layer on a substrate by sputtering was used.

### (c) Wafer for Cap Layer (Silicon Dioxide Layer) Polishing Rate Evaluation

An 8-inch wafer obtained by forming an 800-nm thick silicon dioxide layer on a substrate by plasma CVD was used.

### (d) Wafer for Low Dielectric Insulating Layer (SiOC Layer) Polishing Rate Evaluation

An 8-inch wafer obtained by forming an 800-nm thick SiOC layer on a substrate by plasma CVD was used.

### (5) Evaluation Method of Polishing Rate

The polishing rate was calculated from the film thickness before and after polishing. For the copper layer and the tantalum layer, a sheet resistance measuring apparatus, RS75 (manufactured by KLA-Tencor Corporation), calculating the thickness from the surface resistance by a four-point probe method was used for the measurement of the film thickness. For the low dielectric insulating layer and the cap layer, an optical interference type full-automatic film thickness measuring apparatus, UV1280SE (manufactured by KLA-Tencor Corporation), was used.

### (6) Blanket Wafer Polishing Characteristic Evaluation

For the evaluation of the polishing rate of each of the metal interconnect layer, the barrier layer, the cap layer and the low dielectric insulating layer, the above-mentioned respective blanket wafers were used. For this evaluation, the polishing agent compositions of the formulations shown in Examples of Table 3 were used.

The polishing rates (unit: nm/min) of the copper, tantalum, silicon dioxide and SiOC films, which were obtained by using the blanket wafers, are shown in Table 2. From these results, it can be understood that the polishing agent compositions according to the invention can approximately equalize the polishing rates of the copper, tantalum, silicon dioxide and SiOC films, and are a so-called "nonselective slurry" (nonselective polishing agent composition).

### [Example 17]

A polishing agent composition of Example 17 was prepared in the same manner as in Example 3 with the exception that HAT was substituted with benzotriazole.

Polishing tests were conducted to the copper layer blanket wafer by using the polishing agent compositions of Examples 3 and 17 under the above-mentioned polishing conditions. As a result, a. surface to be polished which was polished with the polishing agent composition of Example 17 showed water repellency by adsorption of BTA. Compared to this, a surface to be polished which was polished with the polishing agent composition of Example 3 containing no benzotriazole showed hydrophilicity, resulting in good results.

**[Table1]**

| Example | Abrasive Grain % by mass | Oxidizing Agent % by mass | Compound Represented by Formula 1 % by mass | Pullulan % by mass | Acid % by mass | Water-Soluble Polymer % by mass | Alkali % by mass | pH of Polishing Agent | pH Buffering Agent % by mass | Organic Solvent % by mass |
|---|---|---|---|---|---|---|---|---|---|---|
| Example 1 | Silica 6.0 | H2O2 0.5 | HAT 1.0 | 0.1 | Nitric acid 0.6 | PA 0.1 | KOH 0.6 | 2.5 | Citric acid 0.2 | NMP 3.0 |
| Example 2 | Silica 6.0 | H2O2 0.5 | HAT 1.0 | 0.1 | Nitric acid 0.6 | PA 0.1 | KOH 0.6 | 2.5 | Citric acid 0.2 | BL 5.0 |
| Example 3 | Silica 6.0 | H2O2 0.5 | HAT 1.0 | 0.1 | Nitric acid 0.6 | PA 0.1 | KOH 0.6 | 2.5 | Citric acid 0.2 | PGM 3.0 |
| Example 4 | Silica 3.0 | H2O2 0.2 | Not added | Not added | Nitric acid 0.6 | Not added | KOH 0.6 | 2.5 | Citric acid 0.2 | EG 1.5 |
| Example 5 | Silica 3.0 | H2O2 1.0 | Not added | Not added | Nitric acid 0.6 | Not added | KOH 0.6 | 2.5 | Citric acid 0.2 | EG 1.5 |
| Example 6 | Silica 3.0 | H2O2 1.0 | Not added | Not added | Nitric acid 0.6 | Not added | KOH 0.9 | 10.0 | Citric acid 0.2 | EG 1.5 |
| Example 7 | Silica 6.0 | H2O2 0.5 | 1HT 1.0 | 0.1 | Nitric acid 0.6 | Not added | KOH 0.6 | 2.5 | Citric acid 0.2 | NMP 3.0 |
| Example 8 | Silica 3.0 | H2O2 1.0 | 1HT 0.5 | Not added | Nitric acid 0.6 | Not added | KOH 0.6 | 3.0 | Citric acid 0.2 | EG 1.5 |

H2O2: Hydrogen peroxide
HAT: 5-Amino-1H-tetrazole
1HT: 1H-Tetrazole
NMP: N-Methylpyrrolidone
BL: γ-Butyrolactone
PGM: Propylene glycol monomethyl ether
EG: Ethylene glycol
PA: Polyacrylic acid

**[Table 2]**

| Example | Cu Polishing Rate nm/min | Ta Polishing Rate nm/min | SiO2 Polishing Rate nm/min | SiOC Polishing Rate nm/min | Cu/Ta Polishing Rate Ratio | Cu/SiO2 Polishing Rate Ratio | Cu/SiOC Polishing Rate Ratio | SiOC/SiO2 Polishing Rate Ratio |
|---|---|---|---|---|---|---|---|---|
| Example 1 | 52 | 47 | 51 | 49 | 1.11 | 0.98 | 1.06 | 0.96 |
| Example 2 | 49 | 45 | 43 | 34 | 1.09 | 0.88 | 1.44 | 0.79 |
| Example 3 | 51 | 51 | 52 | 42 | 1.00 | 1.02 | 1.21 | 0.81 |
| Example 4 | 206 | 73 | Not performed | 13 | 2.82 | - | - | - |
| Example 5 | Not performed | Not performed | 36 | 10 | - | - | - | 0.28 |
| Example 6 | Not performed | Not performed | 8 | 70 | - | - | - | 8.75 |
| Example 7 | 40 | 51 | 53 | 43 | 0.78 | 1.33 | 0.93 | 0.81 |
| Example 8 | 64 | 80 | 56 | 4 | 0.80 | 0.88 | 16.0 | 0.07 |

**[Table 3]**

| Example | Abrasive Grain % by mass | Oxidizing Agent % by mass | Compound Represented by Formula 1 % by mass | Pullulan % by mass | Acid % by mass | Water-Soluble Polymer % by mass | Alkali % by mass | pH of Polishing Agent | pH Buffering Agent % by mass | Organic Solvent % by mass |
|---|---|---|---|---|---|---|---|---|---|---|
| Example 9 | Silica 5.0 | Not added | HAT 1.0 | Not added | Nitric acid 1.0 | Not added | Not added | 1.0 | Citric acid 0.2 | EG 1.0 |
| Example 10 | Silica 5.0 | Not added | HAT 1.0 | Not added | Nitric acid 1.0 | Not added | KOH 0.6 | 1.5 | Citric acid 0.2 | EG 1.0 |
| Example 11 | Silica 5.0 | Not added | HAT 1.0 | Not added | Nitric acid 1.0 | Not added | KOH 0.7 | 2.0 | Citric acid 0.2 | EG 1.0 |
| Example 12 | Silica 5.0 | Not added | HAT 1.0 | Not added | Nitric acid 1.0 | Not added | KOH 0.9 | 3.0 | Citric acid 0.2 | EG 1.0 |
| Example 13 | Silica 5.0 | Not added | HAT 1.0 | Not added | Nitric acid 1.0 | Not added | KOH 1.0 | 4.0 | Citric acid 0.2 | EG 1.0 |
| Example 14 | Silica 5.0 | Not added | HAT 1.0 | Not added | Nitric acid 1.0 | Not added | Alkali % by mass | pH of Polishing Agent | pH Buffering Agent % by mass | Organic Solvent % by mass |
| Example 15 | Silica 5.0 | Not added | HAT 1.0 | Not added | Nitric acid 1.0 | Not added | Not added | 1.0 | Citric acid 0.2 | EG 1.0 |
| Example 16 | Silica 5.0 | Not added | HAT 1.0 | Not added | Nitric acid 1.0 | Not added | KOH 0.6 | 1.5 | Citric acid 0.2 | EG 1.0 |

**[Table 4]**

| Example | Initial Average Particle Size (nm) | Average Particle Size after Storage at Room Temperature for 10 Days (nm) | Average Particle Size after Storage at 55°C for 3 Days (nm) |
|---|---|---|---|
| Example 9 | 41 | 39 | 40 |
| Example 10 | 40 | 41 | 42 |
| Example 11 | 40 | 48 | 46 |
| Example 12 | 41 | 44 | 43 |
| Example 13 | 40 | 44 | 63 |
| Example 14 | 41 | 57 | 569 |
| Example 15 | 41 | 517 | 646 |
| Example 16 | 38 | 584 | 946 |

While the invention has been described in detail and with reference to the specific embodiments thereof, it would be apparent to those skilled in the art that various changes and modifications may be made therein without departing from the spirit and scope of the invention.
This application is based on Japanese Patent Application No. 2007-108556 filed on Apr. 17, 2007, the contents of which are incorporated herein by reference.

### INDUSTRIAL APPLICABILITY

The use of the polishing agent composition of the invention makes it possible to highly flatly polish a surface to be polished with dishing and erosion inhibited and with scratches decreased in CMP of a production process of buried metal interconnects in a production process of a semiconductor integrated circuit device. Thereby, a semiconductor integrated circuit device inhibited in an increase in interconnect resistance or electro migration and having high reliability can be realized. Further, washing of the surface to be polished after CMP is easy, so that an adverse effect on the subsequent process, which is caused by that components of the polishing agent composition are adsorbed and remain, can be inhibited.

## Claims

1. A polishing agent composition for use in the production of a semiconductor integrated circuit device, which comprises
silica particles,
one or more oxidizing agents selected from the group consisting of hydrogen peroxide, ammonium persulfate and potassium persulfate,
a compound represented by formula (1) (wherein R² and R³ are each independently a hydrogen atom, an alkyl group having 1 to 4 carbon atoms, an alkoxy group having 1 to 4 carbon atoms, a carboxylic acid group or an amino group),
pullulan,
one or more acids selected from the group consisting of nitric acid, sulfuric acid and carboxylic acids, and
water, and
which has a pH within the range of 1 to 5.

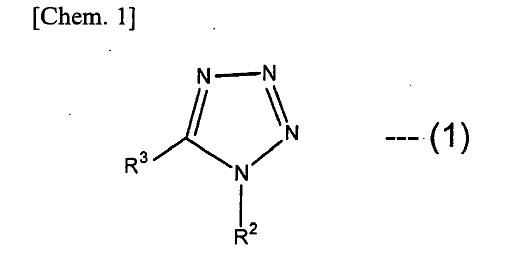

2. The polishing agent composition according to claim 1, wherein the composition contains 0.1 to 20% by mass of the silica particles, 0.01 to 50% by mass of the oxidizing agent, 0.001 to 5% by mass of the compound represented by formula (1) and 0.005 to 20% by mass of pullulan, based on the total amount of the polishing agent composition.

3. The polishing agent composition according to claim 1 or 2, wherein the oxidizing agent is hydrogen peroxide, and the compound represented by formula (1) is 5-amino-1H-tetrazole.

4. The polishing agent composition according to claim 1, 2 or 3, wherein the silica particles have an average particle size of 5 to 300 nm.

5. The polishing agent composition according to any one of claims 1 to 4, wherein the composition further comprises one or more members selected from the group consisting of polyacrylic acid and polyvinyl alcohol.

6. The polishing agent composition according to claim 5, wherein the composition comprises one or more members selected from the group consisting of polyacrylic acid and polyvinyl alcohol in an amount of 0.005 to 20% by mass based on the total amount of the polishing agent composition.

7. The polishing agent composition according to any one of claims 1 to 6, wherein a ratio PR_{cu}/PR_{br} of a copper layer polishing rate PR_{cu} to a barrier layer polishing rate PR_{br}, a ratio PR_{cu}/PR_{sioc} of a copper layer polishing rate PR_{cu} to a SiOC layer polishing rate PR_{sioc}, a ratio PR_{cu}/PRₛᵢₒ₂ of a copper layer polishing rate PR_{cu} to a SiO₂ layer polishing rate PRₛᵢₒ₂, and a ratio PR_{sioc}/PRₛᵢₒ₂ of a SiOC layer polishing rate PR_{sioc} to a SiO₂ layer polishing rate PRₛᵢₒ₂ are each from 0.67 to 1.5.

8. A method for producing a semiconductor integrated circuit device,
wherein the semiconductor integrated circuit device comprises an insulating layer having trench portions and buried metal interconnects formed in the trench portions,
the method comprising a step of polishing a surface to be polished which comprises a barrier layer and a metal interconnect layer formed in this order in the trench portions, using the polishing agent composition according to any one of claims 1 to 7, to form the buried metal interconnects.

9. The method for producing a semiconductor integrated circuit device according to claim 8, wherein the metal interconnect layer comprises copper as a main component, and the barrier layer comprises one or more members selected from the group consisting of tantalum, tantalum alloys and tantalum compounds.

10. The method for producing a semiconductor integrated circuit device according to claim 8 or 9, wherein the insulating layer comprises a low dielectric insulating layer comprising a low dielectric material and a cap layer formed thereon,
and the barrier layer and the metal interconnect layer are formed on the trench portions and the cap layer.
